# EUROPEAN PATENT APPLICATION

(11) **EP 4 565 024 A1**
(43) Date of publication of application: **04.06.2025**
(21) Application number: 23846910.0
(22) Date of filing: 20.07.2023
(51) Int. Cl.: H10B 12/00, H01L 29/40, H01L 29/51

(54) **METHOD FOR MANUFACTURING SEMICONDUCTOR DEVICE**

(30) Priority: 26.07.2022 KR 20220092731
(71) Applicant: HPSP Co., Ltd., Hwaseong-si, Gyeonggi-do 18449 (KR)
(72) Inventor: KIM, Tae Jung, Hwaseong-si Gyeonggi-do 18449 (KR)
(74) Representative: HGF
(86) International application number: PCT/KR2023/010506
(87) International publication number: WO 2024/025251

(57) **Abstract**

The present invention relates to a method for manufacturing a semiconductor device. A method for manufacturing a semiconductor device, according to one embodiment, may comprise the steps of: laminating a plurality of insulating layers and a plurality of sacrificial layers on a substrate; forming an opening penetrating the plurality of insulating layers and the plurality of sacrificial layers; forming a trench by removing the sacrificial layers; laminating a barrier layer inside the trench; laminating a first electrode layer on the barrier layer; laminating a dielectric layer on the first electrode layer; performing heat treatment on the dielectric layer; and laminating a second electrode layer on the dielectric layer.

## Description

### FIELD

The present disclosure relates to a method for manufacturing a semiconductor device.

### DESCRIPTION OF RELATED ART

An electronic system requiring data storage requires a semiconductor device capable of storing high-capacity data therein. It is required to increase the integration density of the semiconductor device in order to meet the excellent performance and low price required by consumers while increasing the data storage capacity. In a two-dimensional or planar semiconductor device, the integration density is mainly determined by an area occupied by a unit memory cell, and thus is greatly affected by the level of fine pattern formation technology. However, since ultra-high-priced equipment is required for pattern miniaturization, the integration density of the two-dimensional semiconductor device is increasing, but is still limited. Accordingly, a three-dimensional semiconductor memory device including three-dimensionally arranged memory cells has been proposed.

### DISCLOSURE

### TECHNICAL PURPOSE

A purpose of the present disclosure is to provide a method for manufacturing a semiconductor device with improved stability and electrical characteristics.

Another purpose of the present disclosure is to provide a method for manufacturing a semiconductor device capable of reducing a magnitude of a leakage current.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

### TECHNICAL SOLUTION

According to an embodiment, a method for manufacturing a semiconductor device may include stacking a plurality of insulating layers and a plurality of sacrificial layers on a substrate, forming an opening penetrating through the plurality of insulating layers and the plurality of sacrificial layers, removing each of the sacrificial layers to form each trench, depositing a barrier layer in the trench, depositing a first electrode layer on the barrier layer, depositing a dielectric layer on the first electrode layer, performing a heat treatment on the dielectric layer, and depositing a second electrode layer on the dielectric layer.

In one embodiment, the heat treatment may include a first heat treatment performed in a hydrogen atmosphere.

In one embodiment, the heat treatment may include a first heat treatment performed in a hydrogen atmosphere and a second heat treatment performed in an oxygen atmosphere.

In one embodiment, the heat treatment may be performed at a temperature of 200°C to 1000°C.

In one embodiment, an atmospheric pressure of the gas supplied when the heat treatment is performed may be in a range of 2 atm to 50 atm.

In one embodiment, the insulating layer may include silicon (Si), and the sacrificial layer may include silicon germanium (SiGe).

In one embodiment, the dielectric layer may include at least one of hafnium oxide (HfO₂), zirconium oxide (ZrO₂), vanadium oxide (VO₂), titanium oxide (TiO₂), tin oxide (SnO₂), aluminum oxide (Al₂O₃), zinc oxide (ZnO), hafnium silicon oxide (HfSiO), zirconium silicon oxide (ZrSiO), or niobium oxide (Nb₂O₅).

### TECHNICAL EFFECT

According to the embodiments, defects or impurities in the dielectric layer may be removed via the heat treatment performed under the hydrogen atmosphere. Accordingly, the performance and reliability of the semiconductor device may be improved. In addition, a leakage current of the semiconductor device may be reduced.

### BRIEF DESCRIPTION OF DRAWINGS

FIGS. 1 to 6 illustrate a process of manufacturing a semiconductor device according to an embodiment.
FIG. 7 is a graph comparing a leakage current of a general semiconductor device with a leakage current of a semiconductor device manufactured by a method for manufacturing a semiconductor device according to an embodiment.
FIG. 8 is a graph comparing a thin film density of a dielectric layer of a general semiconductor device with a thin film density of a dielectric layer of a semiconductor device manufactured by a method for manufacturing a semiconductor device according to an embodiment.

### DETAILED DESCRIPTIONS

The above-described purposes, features, and advantages will be described in detail with reference to the accompanying drawings, and accordingly, a person having ordinary skill in the art to which the present disclosure belongs will be able to easily implement the embodiments of the present disclosure. In describing the present disclosure, when it is determined that a detailed description of known technologies related to the present disclosure may unnecessarily obscure a gist of the present disclosure, the detailed description thereof will be omitted. Hereinafter, preferred embodiments of the present disclosure will be described in detail with reference to the accompanying drawings. In the drawings, the same reference numerals refer to the same or similar elements.

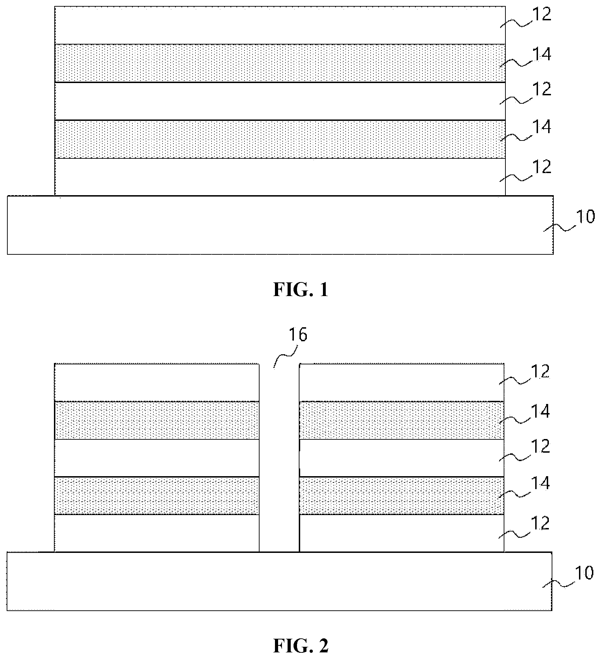

FIGS. 1 to 6 illustrate a process of manufacturing a semiconductor device according to an embodiment.

Referring to FIG. 1, a plurality of insulating layers 12 and a plurality of sacrificial layers 14 may be alternately and repeatedly stacked with each other while being disposed on a substrate 10. The plurality of insulating layers 12 and the plurality of sacrificial layers 14 may be epitaxially grown. In one embodiment, the substrate 10 may be embodied as a single crystal silicon wafer. Each insulating layer 12 may include silicon (Si). Each sacrificial layer 14 may include silicon germanium (SiGe). The sacrificial layers 14 may have substantially the same thickness, and the insulating layers 12 may have different thicknesses in some areas.

When the sacrificial layer 14 is made of silicon germanium (SiGe), a content of germanium (Ge) in the sacrificial layer 14 may be higher than a content of silicon (Si) therein. When the content of germanium (Ge) in the sacrificial layer 14 is higher than the content of silicon (Si) therein, an etching selectivity of the sacrificial layer 14 may be higher than an etching selectivity the insulating layer 12 in a manufacturing process to be described later. However, the component or the component content ratio of the sacrificial layer 14 is not limited to the above-described embodiment, and the component or the component content ratio of the sacrificial layer 14 may vary as necessary.

Next, referring to FIG. 2, an opening 16 vertically penetrating through the sacrificial layers 14 and the insulating layers 12 may be formed. For example, the sacrificial layers 14 and the insulating layers 12 may be etched via patterning to form the opening 16. Sidewalls of the sacrificial layers 14 and the insulating layers 12 may be exposed through the opening 16. In a subsequent process, the sacrificial layers 14 may be removed using the opening 16.

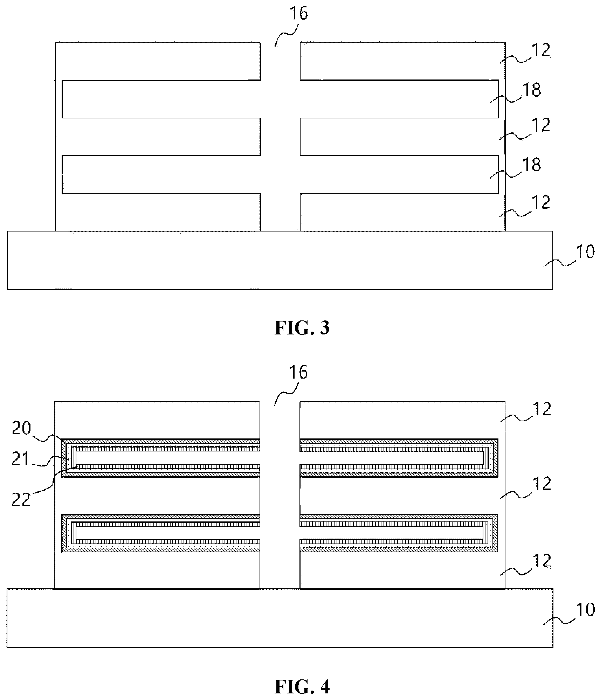

Next, referring to FIG. 3, the sacrificial layers 14 may be removed using a difference between the etch selectivity of the sacrificial layer 14 and the etch selectivity of the insulating layer 12. The sacrificial layers 14 are removed to form a plurality of trenches 18. The sacrificial layer 14 may be made of, for example, silicon germanium (SiGe). In this case, when a content of germanium (Ge) constituting the sacrificial layer 14 is higher than that of silicon (Si) constituting the sacrificial layer 14, an etch selectivity of the sacrificial layer 14 may be higher than that of the insulating layer 12 made of silicon (Si). Accordingly, the sacrificial layers 14 may be removed by performing wet etching using, for example, hydrochloric acid (HCl) or the like.

Next, referring to FIG. 4, a barrier layer 20, a first electrode layer 21, and an dielectric layer 22 may be sequentially stacked in each trench 18. The barrier layer 20 may include a metal material (e.g., Ti, TiN, or Co). The first electrode layer 21 may include a metal material. For example, the first electrode layer 21 may include a conductive material such as a metal nitride, a metal oxide, a metal silicide, conductive carbon, polysilicon, or a combination thereof. In another example, the first electrode layer 21 may include TiN, Al, W, or Ru. However, the type of the metal material included in the first electrode layer 21 is not limited to the materials listed above.

The dielectric layer 22 may include a high-k dielectric material. The dielectric layer 22 may be deposited in an atomic layer deposition (ALD) process.

In one embodiment, the high-k material included in the dielectric layer 22 may include, for example, at least one of hafnium oxide (HfO₂), zirconium oxide (ZrO₂), vanadium oxide (VO₂), titanium oxide (TiO₂), tin oxide (SnO₂), aluminum oxide (Al₂O₃), zinc oxide (ZnO), hafnium silicon oxide (HfSiO), zirconium silicon oxide (ZrSiO), or niobium oxide (Nb₂O₅). However, the type of the high-k material is not limited to the above-described embodiment.

After the dielectric layer 22 has been formed as shown in FIG. 4, a first heat treatment may be performed on the dielectric layer 22. In one embodiment, the first heat treatment on the dielectric layer 22 may be performed in a gas atmosphere containing a hydrogen component. For example, the first heat treatment on the dielectric layer 22 may be performed in an H₂ or D₂ atmosphere. In one embodiment, an atmospheric pressure of the gas containing the hydrogen component supplied when the first heat treatment is performed on the dielectric layer 22 may be in a range of 2 atm to 50 atm. In one embodiment, the first heat treatment on the dielectric layer 22 may be performed at a temperature of 200°C to 1000°C.

In another embodiment, the first heat treatment on the dielectric layer 22 may be performed in a gas atmosphere containing a nitrogen component. For example, the first heat treatment on the dielectric layer 22 may be performed in a N₂ atmosphere. In one embodiment, the atmospheric pressure of the gas containing the nitrogen component supplied when the first heat treatment is performed on the dielectric layer 22 may be in a range of 2 atm to 50 atm. In one embodiment, the first heat treatment on the dielectric layer 22 may be performed at a temperature of 200°C to 1000°C.

As the semiconductor device is scaled down, a thickness of the dielectric layer 22 becomes smaller than the limit, and thus the leakage current may increase. The leakage current is caused by a defect or impurity present in the dielectric layer 22. In particular, the number of defects in a structure of the dielectric layer 22 made of the high-k material is greater by at least about 100 times than the number of defects in a structure of another insulating film (e.g., SiO₂), thereby increasing the possibility of generating the leakage current. However, when the above-described first heat treatment is performed, defects or impurities of the dielectric layer 22 may be removed. Accordingly, the film quality of the dielectric layer 22 may be improved and the leakage current may be reduced.

In another embodiment, after the first heat treatment has been performed on the dielectric layer 22, a second heat treatment may be additionally performed on the dielectric layer 22. In another embodiment, the second heat treatment on the dielectric layer 22 may be performed in a gas atmosphere containing an oxygen component. For example, the second heat treatment on the dielectric layer 22 may be performed in an atmosphere of O₂, O₃, or H₂O. In one embodiment, the atmospheric pressure of the gas containing the oxygen component supplied when the second heat treatment is performed on the dielectric layer 22 may be in a range of 2 atm to 50 atm. In one embodiment, the second heat treatment on the dielectric layer 22 may be performed at a temperature of 200°C to 1000°C. The film quality of the dielectric layer 22 may be further improved and the leakage current may be further reduced due to the second heat treatment on the dielectric layer 22.

Depending on an embodiment, only the first heat treatment may be performed on the dielectric layer 22.

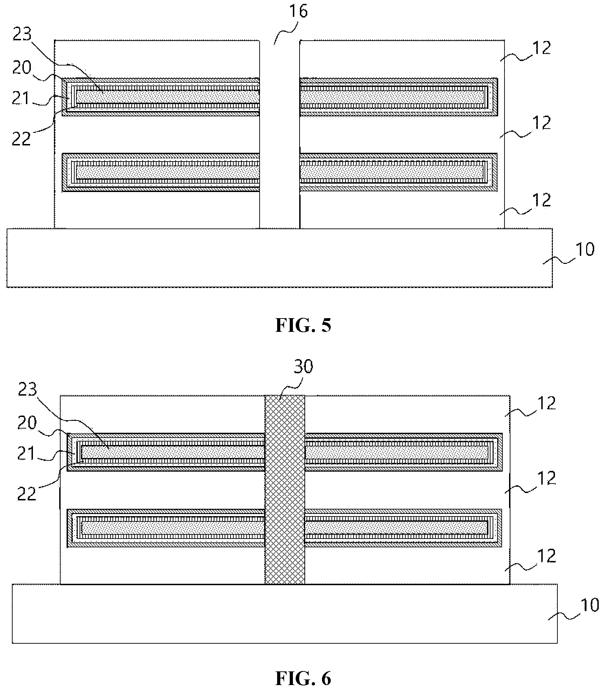

Next, referring to FIG. 5, a second electrode layer 23 may be formed on the dielectric layer 22. The second electrode layer 23 may include a metal material. For example, the second electrode layer 23 may include a conductive material such as a metal nitride, a metal oxide, a metal silicide, conductive carbon, polysilicon, or a combination thereof. In another example, the second electrode layer 23 may include TiN, Al, W, or Ru. However, the type of the metal material included in the second electrode layer 23 is not limited to the materials listed above.

Next, referring to FIG. 6, a cell structure 30 may be formed in the opening 16. In one embodiment, the cell structure 30 may include at least some of at least one component (e.g., a transistor) electrically connected to the first electrode layer 21 or the second electrode layer 23, or a conducting wire (e.g., a word line or a bit line) electrically connected to the at least one component electrically connected to the first electrode layer 21 or the second electrode layer 23.

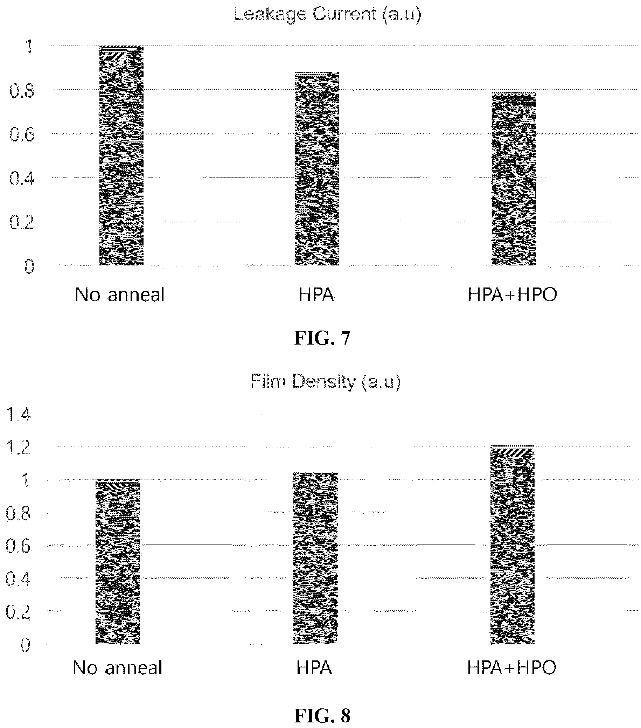

FIG. 7 is a graph comparing a leakage current of a general semiconductor device with a leakage current of a semiconductor device manufactured by a method for manufacturing a semiconductor device according to an embodiment.

In FIG. 7, No anneal represents a leakage current value of a general semiconductor device in which the heat treatment is not performed on a dielectric layer. In addition, in FIG. 7, HPA represents a leakage current value of a semiconductor device on which the first heat treatment has been performed on the dielectric layer according to an embodiment. In addition, in FIG. 7, HPA+HPO represents a leakage current value of a semiconductor device in which the first heat treatment and the second heat treatment are sequentially performed on the dielectric layer according to another embodiment. For reference, each of the first heat treatment and the second heat treatment was performed for 1 hour at 500°C/20 atmospheric pressure, the first heat treatment was performed in a hydrogen atmosphere, and the second heat treatment was performed in an oxygen atmosphere.

As illustrated in FIG. 7, when the leakage current value of the semiconductor in which the heat treatment is not performed on the dielectric layer is 1, the leakage current value of the semiconductor device in which the first heat treatment is performed on the dielectric layer is 0.87 according to an embodiment. In addition, according to another embodiment, the leakage current value of the semiconductor device in which the first heat treatment and the second heat treatment are sequentially performed on the dielectric layer is 0.79. According to the experimental results, it may be identified that the leakage current of the semiconductor device is reduced by removing defects or impurities in the dielectric layer via the first heat treatment or the first and second heat treatment. In particular, it may be identified that when the second heat treatment is additionally performed in an oxygen atmosphere, the leakage current is additionally reduced by about 10%, compared to the case where only the first heat treatment is performed.

FIG. 8 is a graph comparing a thin film density of a dielectric layer of a general semiconductor device with a thin film density of a dielectric layer of a semiconductor device manufactured by a method for manufacturing a semiconductor device according to an embodiment.

In FIG. 8, No anneal represents a thin film density of a dielectric layer of a general semiconductor device in which the heat treatment is not performed on the dielectric layer. In addition, in FIG. 8, HPA represents a thin film density of a dielectric layer of a semiconductor device on which the first heat treatment has been performed on the dielectric layer according to an embodiment. In addition, in FIG. 8, HPA+HPO represents the thin film density of the dielectric layer of the semiconductor device in which the first heat treatment and the second heat treatment are sequentially performed on the dielectric layer according to another embodiment. For reference, each of the first heat treatment and the second heat treatment was performed for 1 hour at 500°C/20 atmospheric pressure, the first heat treatment was performed in a hydrogen atmosphere, and the second heat treatment was performed in an oxygen atmosphere.

As illustrated in FIG. 8, when the thin film density of the general semiconductor device in which the heat treatment on the dielectric layer is not performed is 1, the thin film density of the dielectric layer of the semiconductor device in which the first heat treatment on the dielectric layer is performed according to an embodiment is 1.05. In addition, according to another embodiment, the density of the thin film of the semiconductor device in which the first heat treatment and the second heat treatment are sequentially performed on the dielectric layer is 1.21. According to the experimental results, it may be identified that the film quality of the dielectric layer is improved by removing defects or impurities in the dielectric layer via the first heat treatment or the first and second heat treatment. In particular, it may be identified that when the second heat treatment is additionally performed in an oxygen atmosphere, the density of the thin film further increases by about 20%, compared to the case where only the first heat treatment is performed.

According to the above-described embodiments, the defects or impurities in the dielectric layer may be removed by performing only the first heat treatment on the dielectric layer under a hydrogen atmosphere or performing the first heat treatment on the dielectric layer under a hydrogen atmosphere and, subsequently, the second heat treatment on the dielectric layer under an oxygen atmosphere. Accordingly, the film quality of the dielectric layer is improved, and the leakage current is reduced. Accordingly, the stability and electrical characteristics of the semiconductor device may be improved. An example of the semiconductor device according to an embodiment may be a dynamic random access memory (DRAM).

Although the present disclosure has been described above with reference to the accompanying drawings, the present disclosure is not limited by the embodiments disclosed herein and the drawings, and it is obvious that various modifications may be made by those skilled in the art within the scope of the technical idea of the present disclosure. In addition, although the effects based on the configuration of the present disclosure are not explicitly described above in the description of the embodiment of the present disclosure, it is obvious that predictable effects from the configuration should also be recognized.

## Claims

1. A method for manufacturing a semiconductor device, the method comprising:
stacking a plurality of insulating layers (12) and a plurality of sacrificial layers (14) on a substrate (10);
forming an opening (16) penetrating through the plurality of insulating layers (12) and the plurality of sacrificial layers (14);
removing each of the sacrificial layers (14) to form each trench (18);
depositing a barrier layer (20) inside each trench (18);
depositing a first electrode layer (21) on the barrier layer (20);
depositing a dielectric layer (22) on the first electrode layer (21);
performing heat treatment on the dielectric layer (22); and
depositing a second electrode (23) layer on the dielectric layer (22).

2. The method for manufacturing the semiconductor device of claim 1, wherein the heat treatment includes a first heat treatment performed in a hydrogen atmosphere.

3. The method for manufacturing the semiconductor device of claim 1, wherein the heat treatment includes a first heat treatment performed in a hydrogen atmosphere and a second heat treatment performed in an oxygen atmosphere.

4. The method for manufacturing the semiconductor device of claim 1, wherein the heat treatment is carried out at a temperature of 200°C to 1000°C.

5. The method for manufacturing the semiconductor device of claim 1, wherein an atmospheric pressure of gas supplied when the heat treatment is performed is in a range of 2 atm to 50 atm.

6. The method for manufacturing the semiconductor device of claim 1, wherein the insulating layer includes silicon (Si) and the sacrificial layer includes silicon germanium (SiGe).

7. The method for manufacturing the semiconductor device of claim 1, wherein the dielectric layer (22) includes at least one of hafnium oxide (HfO₂), zirconium oxide (ZrO₂), vanadium oxide (VO₂), titanium oxide (TiO₂), tin oxide (SnO₂), aluminum oxide (Al₂O₃), zinc oxide (ZnO), hafnium silicon oxide (HfSiO), zirconium silicon oxide (ZrSiO), or niobium oxide (Nb₂O₅).
